# EUROPÄISCHE PATENTANMELDUNG

(11) **EP 1 793 447 A1**
(43) Veröffentlichungstag der Anmeldung: **06.06.2007**
(21) Anmeldenummer: 06024667.5
(22) Anmeldetag: 29.11.2006
(51) Int. Cl.: H01Q 1/12, H01Q 1/38, H01Q 1/40, H05K 1/00, H05K 3/10, B60R 16/02

(54) **Integration von funktionalen Schichten in oder an transparenten Kunststoffteilen des Automobilbaus**

(30) Priorität: 30.11.2005 DE 102005057027
(71) Anmelder: Hirschmann Car Communication GmbH, 72654 Neckartenzlingen (DE)
(72) Erfinder: Petersen, Ingmar, 73733 Esslingen (DE); Schwarz, Bernd, 72141 Waldorfhäslach (DE); Pfletschinger, Markus, 72800 Eningen (DE)
(74) Vertreter: Thul, Hermann

(57) **Zusammenfassung**

Die Erfindung betrifft ein transparentes Kunststoffteil (1, 11) aus einem elektrisch nicht leitfähigen Material, auf, an oder in dem elektrisch leitfähige Strukturen (2) integriert sind, ausgebildet zur Anwendung in einem Fahrzeug, wobei erfindungsgemäß vorgesehen ist, dass die mittels eines Druckverfahrens aufgebrachten elektrisch leitfähigen Strukturen (2) außen liegend sind.

## Beschreibung

Die Erfindung betrifft die Integration von funktionalen Schichten, insbesondere elektrisch leitfähige Strukturen, wie zum Beispiel Antennen, Heizungen und Photovoltaik in oder auf transparenten Kunststoffen, welche im Automobilbau Anwendung finden.

Vermehrt finden transparente Kunststoffe Einsatz im Automobilbau. Gegenüber Glas weisen sie eine Vielzahl von Vorteilen auf. Die Gewichtseinsparung schlägt sich direkt in einem reduzierten Kraftstoffverbrauch nieder. Parallel hierzu lassen sich durch die größere Designfreiheit durch mannigfaltige und nahezu uneingeschränkte Formgebungen beim Spritzguss- oder Spritzprägeverfahren günstigere aerodynamische Eigenschaften hervorrufen. Auch dies senkt den Energieverbrauch. Die Herstellung solcher Bauteile bietet darüber hinaus effektive Prozesszeiten. Durch die Nutzung dieser Kunststoffe zum Beispiel als Seiten- und Heckscheiben oder als Dach eines Automobils wird eine Absenkung des Fahrzeugschwerpunktes hervorgerufen, welche die Fahrstabilität positiv beeinflusst.

Der Erfindung liegt die Aufgabe zu Grunde, ein transparentes Kunststoffteil aus einem elektrisch nicht leitfähigen Material, auf, an oder in dem elektrisch leitfähige Strukturen integriert sind, welches zur Anwendung in einem Fahrzeug ausgebildet ist, bereit zu stellen, mit dem die eingangs geschilderten Nachteile vermieden bzw. die eingangs geschilderten Vorteile beibehalten werden und mit dem auf einfache Art und Weise Leiterstrukturen für die Stromübertragung, Signalübertragung, als Antennen oder für die Photovoltaik aufzubringen sind.

Diese Aufgabe ist durch die Merkmale des Patentanspruches 1 gelöst.

Vorzugsweise Polycarbonat (PC) und Polymethylmethacrylat (PMMA) findet im Bereich der Scheiben Anwendung. Die Eigenschaften stehen hierbei dem Glas nahezu in nichts nach. Polycarbonat splittert nicht, ist schlagfest, einfärbbar und dimensionsstabil. Die bei den genannten Materialien nicht vorhandene Kratzfestigkeit ist durch zusätzliches Auftragen einer Antikratzschicht (zum Beispiel durch keramische Nanopartikel in Siliziumschicht) zu beseitigen. Die Möglichkeiten der Bearbeitung des Kunststoffs durch zum Beispiel Bohren, Sägen, Fräsen, Schweißen und Kleben sind weitere Vorteile gegenüber dem konventionellen Glaseinsatz. Mit der Integration weiterer, von den Automobilbauern beziehungsweise von den Kunden gewünschten Funktionen, wie zum Beispiel Antennen, Antennensysteme, Heizungen und Photovoltaik wird also der Einsatz von transparenten Kunststoffen als Alternative zum Glas vorangetrieben und ist Gegenstand dieser Erfindung.

Erfindungsgemäß ist vorgesehen, dass die mittels eines Druckverfahrens aufgebrachten elektrisch leitfähigen Strukturen außen liegend auf dem transparenten Kunststoffteil sind. Dies hat den Vorteil, dass das transparente Kunststoffteil entsprechend seinem späteren Einsatzweck in der entsprechenden Form fertig hergestellt, gegebenenfalls fein bearbeitet werden kann, so dass anschließend in einem Druckverfahren, insbesondere in einem Siebdruckverfahren, die elektrisch leitfähigen Strukturen aufgebracht werden können und damit außen liegend auf dem transparenten Kunststoffteil angebracht sind. Damit wird sowohl bezüglich der Herstellung und Formgebung des transparenten Kunststoffteiles als auch bezüglich der Herstellung und Formgebung der elektrisch leitfähigen Strukturen die größtmögliche Designfreiheit beibehalten, um in dem Kunststoffteil mittels der elektrisch leitfähigen Strukturen die gewünschte Funktion zu erzielen.

Ausführungsbeispiele der Erfindung, auf die diese jedoch nicht beschränkt sind, sind sowohl in den Unteransprüchen angegeben, als auch in den Figuren gezeigt und im Folgenden beschrieben.

Es zeigen:
- Figur 1:: Das transparente Kunststoffbauteil wird direkt bedruckt,
- Figur 2:: Das transparente Kunststoffbauteil wird direkt bedruckt. Anschließend wurde eine Schutzfolie auflaminiert oder aufkaschiert. Diese Schutzfolie könnte auch eine aufgebrachte Siliziumschicht (Antikratzschicht) sein,
- Figur 3:: Eine transparente Folie wurde bedruckt und diese anschließend auf das transparente Bauteil gefügt. Die leitenden Strukturen können hierbei innenliegend sein. Es werden beide Formen gezeigt,
- Figur 4:: Eine transparente Kunststofffolie wird bedruckt und diese dann in-mould mit dem transparenten Kunststoff hinterspritzt. Es kann, wie dargestellt, eine zusätzliche Schutzschicht aufgebracht werden,
- Figur 5:: Eine transparente Kunststofffolie wird bedruckt und dient für den in-mould-Prozess als Transfermedium, welches die leitenden Strukturen in das transparente Zielbauteil überträgt. Schutzschicht möglich wie in Figur 4.

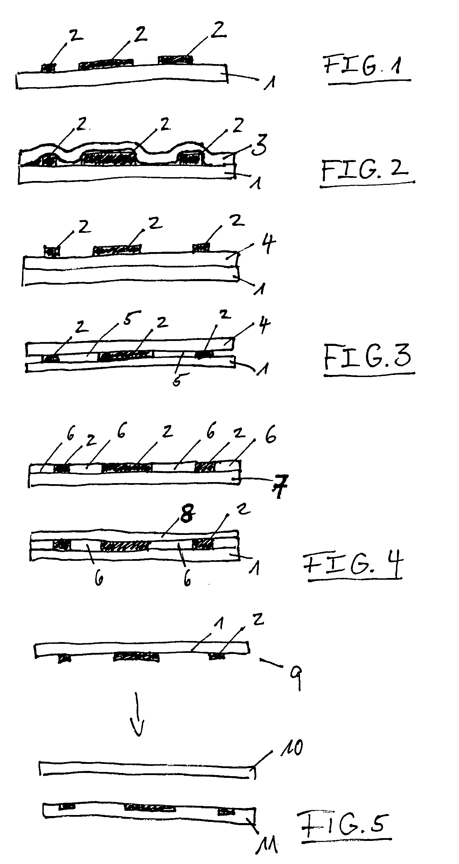

Figur 1 zeigt, soweit im Einzelnen dargestellt, ein transparentes Kunststoffteil 1 mit darauf aufgedruckten elektrisch leitenden Strukturen 2. Das transparente Kunststoffteil 1 besteht vorzugsweise aus Polycarbonat (PC) oder Polymethylmethacrylat (PMMA), wohingegen die elektrisch leitenden Strukturen in einem Druckverfahren, vorzugsweise einem Siebdruckverfahren, aufgebracht worden sind. Beim Drucken werden vorzugsweise elektrisch leitfähige Pasten verwendet, die in jede gewünschte Form für die elektrisch leitenden Strukturen 2 gebracht werden können. Als äquivalente Alternative zu dem Druckverfahren sind auch andere Verfahren denkbar, wie z.B. Besprühen, Lackierung, Ink-Jet, Airbrush oder Bespattern, wobei diese Aufzählung nur beispielhaft aber nicht abschließend ist.

Figur 2 zeigt ein Ausführungsbeispiel, bei dem über den transparenten Kunststoffteil 1 und den leitenden Strukturen 2 eine Schutzschicht 3 angebracht ist, so dass die elektrisch leitfähigen Strukturen 2 innen liegend sind. Diese Schutzschicht 3 kann eine Schutzfolie sein, die z.B. auflaminiert oder aufkaschiert wird. Alternativ könnte dies Schutzfolie auch eine aufgebrachte Siliziumschicht sein, die die Aufgabe hat, sowohl die leitenden Strukturen 2 vor Beschädigungen (insbesondere Unterbrechungen) und das transparente Kunststoffteil 1 vor Verkratzen (Antikratzschicht) zu schützen.

Figur 3 zeigt, dass eine transparente Folie 4 bedruckt wird mit den elektrisch leitenden Strukturen 2 und diese Folie 4 auf das Kunststoffteil aufgebracht, insbesondere aufgeklebt oder auflaminiert oder aufkaschiert wird. Der obere Teil der Figur 3 zeigt, dass die Kunststofffolie 4 mit der den elektrisch leitenden Strukturen 2 gegenüber liegenden Oberfläche auf das Kunststoffteil 1 aufgebracht wird. Der untere Teil der Figur 3 zeigt die umgekehrte Anordnung, bei der die Kunststofffolie 4 mit der Seite, auf der die leitenden Strukturen 2 aufgedruckt worden sind, auf die Oberfläche des Kunststoffteiles 1 aufgebracht wird. Damit sind die elektrisch leitfähigen Strukturen 2 auf Grund der zusätzlich aufgebrachten Schicht in Form der Folie 4 innen liegend ausgebildet. Die Befestigung der Folie 4 an dem Kunststoffteil 1 kann partiell oder großflächig, insbesondere vollständig flächig erfolgen.

Figur 4 zeigt, dass eine transparente Kunststofffolie 7 bedruckt wird und diese dann mit einem transparenten Kunststoff 6 hinterspritzt wird. Bei der oberen Darstellung der Figur 4 ist erkennbar, dass auf der transparenten Kunststofffolie 7 (alternativ das starre transparente Kunststoffteil 1) die elektrisch leitenden Strukturen aufgedruckt und durch ein entsprechendes Verfahren (z.B. ein In-Mould-Verfahren) ein transparenter Kunststoff an die Kunststofffolie 7 (oder das Kunststoffteil 1) angespritzt bzw. hinterspritzt wird. Dabei ist es gemäß der oberen Darstellung der Figur 4 von besonderem Vorteil, wenn die Oberfläche des angespritzten Kunststoffes 6 mit der Oberfläche der elektrisch leitenden Strukturen abschließt, um eine ebene Fläche zu erzeugen. Alternativ oder ergänzend dazu ist es selbstverständlich möglich, dass der angespritzte Kunststoff 6 auch die Oberfläche, die von der Kunststofffolie 7 absteht, der elektrisch leitenden Strukturen mit zu überspritzen.

In der unteren Darstellung der Figur 4 ist noch gezeigt, dass sowohl der angespritzte bzw. hinterspritzte transparente Kunststoff 6 als auch die elektrisch leitenden Strukturen 2 von einer zusätzlichen Schutzschicht 8, insbesondere einer Antikratzschutzschicht, umgeben ist.

In Figur 5 ist dargestellt, dass ein Transfermedium 9 vor der eigentlichen Durchführung eines Einspritzprozesses mit den leitenden Strukturen 2 versehen worden ist, während dieses vorbereitete Transfermedium 9 an dem transparenten Kunststoffteil 1, alternativ an der transparenten Kunststofffolie 7, angebracht wird. Über eine Transferfolie 10 werden dann während des Einspritzprozesses (In-Mould-Verfahren) die elektrisch leitenden Strukturen 2 auf das Zielbauteil, nämlich ein transparentes Kunststoffteil 11 mit leitenden Strukturen, übertragen. Auch das fertig gestellte transparente Kunststoffteil 11 kann mit einer zusätzlichen Beschichtung, insbesondere der Antikratzbeschichtung 3, versehen werden.

Die in den Figuren 1 bis 5 gezeigten Kunststoffteile 1, 11 dienen in erfindungsgemäßer Weise der Verscheibung von Fahrzeugen, in dem sie beispielsweise als Fensterscheiben (Front-, Heck- oder Seitenscheiben) oder auch im Fahrzeugdach (transparentes und damit lichtdurchlässiges Schiebedach) eingesetzt werden.

Die elektrisch leitenden Strukturen 2 sind in ihrer geometrischen Erstreckung, insbesondere ihrer Länge, Breite, Höhe, Querschnitt sowie Längserstreckung, entsprechend der Funktion ausgebildet. So können die elektrisch leitenden Strukturen 2 beispielsweise Antennenstrukturen sein, um hochfrequente Signale zu empfangen bzw. zu senden. Dazu sind beispielsweise bei einem Diversity-System mehrere gradlinige, elektrisch leitfähige Strukturen 2 parallel und/oder im rechten Winkel auf einer Fahrzeugscheibe zueinander angeordnet, weisen aber einen gewissen Mindestabstand auf, damit sich die Empfangs- bzw. Sendeeigenschaften nicht gegenseitig stören. Sind die elektrisch leitenden Strukturen 2 beispielsweise eine Heckscheibenheizung, so ist es denkbar, dass zwei senkrecht an den Seiten der Heckscheibe angeordnete elektrisch leitende Strukturen 2 vorhanden sind und sich dazwischen eine Vielzahl, dicht zueinander benachbart angeordneter weiterer elektrisch leitender Strukturen 2 befinden, die extrem dünn in ihrem Querschnitt ausgebildet sind, damit sie die optischen Eigenschaften des transparenten Kunststoffteiles 1 in Form der Heckscheibe nicht stören. Daneben ist es denkbar, dass die elektrisch leitenden Strukturen 2 für die Signalübertragung, der Stromübertragung oder dergleichen dienen oder auch vorzugsweise als Solarzellen ausgebildet sind. Die letztgenannte Ausgestaltung bietet den Vorteil auf transparenten Kunststoffteilen wie z.B. Fahrzeugscheiben, Solarzellen in Form der elektrisch leitenden Strukturen 2 aufzudrucken, deren Energie über weitere elektrisch leitende Strukturen 2 z.B. einer Steckverbindung oder einem elektronischen Gerät zugeführt wird, von wo aus z.B. ein Lüfter mit der Sonnenenergie betrieben wird, um bei hohen Temperaturen den Innenraum des Fahrzeuges zu belüften bzw. zu kühlen. Neben dieser Lüfterfunktion ist es aber auch denkbar, dass Solarzellen in Form der elektrisch leitenden Strukturen 2 auf dem transparenten Kunststoffteil 1 aufgedruckt sind, um Energie für andere Verbraucher bereit zu stellen.

Die genannten Ausführungen sind beispielhaft. Eine Kombination dieser Herangehensweisen ist möglich. Auch ist eine thermische Vor- und Nachbehandlung der Komponenten möglich. Die Gestalt ist demzufolge mannigfaltig.

### Bezugszeichenliste

- 1.: Transparentes Kunststoffteil
- 2.: leitende Strukturen
- 3.: Schutzschicht (Folie, Siliziumschicht, oder andere)
- 4.: Transparente Kunststofffolie
- 5.: Fügematerial (wie zum Beispiel Klebstoff)
- 6.: angespritzter bzw. hinterspritzter transparenter Kunststoff
- 7.: transparente Kunststofffolie
- 8.: Schutzschicht
- 9.: Transfermedium während des Einspritzprozesses
- 10.: Transferfolie
- 11.: Transparentes Kunststoffteil mit leitenden Strukturen

## Patentansprüche

1. Transparentes Kunststoffteil (1, 11) aus einem elektrisch nicht leitfähigen Material, auf, an oder in dem elektrisch leitfähige Strukturen (2) integriert sind, ausgebildet zur Anwendung in einem Fahrzeug, **dadurch gekennzeichnet, dass** die mittels eines Druckverfahrens aufgebrachten elektrisch leitfähigen Strukturen (2) außen liegend sind.

2. Transparentes Kunststoffteil (1, 11) nach Anspruch 1, **dadurch gekennzeichnet, dass** die elektrisch leitfähigen Strukturen (2) innen liegend sind.

3. Transparentes Kunststoffteil (1, 11) nach Anspruch 1, **dadurch gekennzeichnet, dass** die elektrisch leitfähigen Strukturen (2) aufgrund einer zusätzlich aufgebrachten Schicht (3, 8) innen liegend sind.

4. Transparentes Kunststoffteil (1, 11) nach Anspruch 3, **dadurch gekennzeichnet, dass** die die zusätzlich aufgebrachte Schicht eine transparente Folie (7) ist.

5. Transparentes Kunststoffteil (1, 11) nach Anspruch 3, **dadurch gekennzeichnet, dass** die die zusätzlich aufgebrachte Schicht eine Antikratzbeschichtung (3) ist.

6. Transparentes Kunststoffteil (1, 11) nach Anspruch 1 und 2, **dadurch gekennzeichnet, dass** das transparente Kunststoffbauteil ein gefügtes Bauteil bestehend aus einem Spritzguss- und Folienteil ist.

7. Transparentes Kunststoffteil (1) nach Anspruch 1 und 2, **dadurch gekennzeichnet, dass** das transparente Kunststoffbauteil eine hinterspritze, transparente Kunststofffolie (6, 7) ist.

8. Transparentes Kunststoffteil (1) nach Anspruch 1 oder 2, **dadurch gekennzeichnet, dass** das transparente Kunststoffbauteil ein nachträglich durch Verklebung gefügtes Spritzguss-Folienteil ist.

9. Transparentes Kunststoffteil (1) nach Anspruch 1 oder 2, **dadurch gekennzeichnet, dass** das transparente Kunststoffbauteil ein extern gefügtes Spritzguss- und Folienteil ist.

10. Transparentes Kunststoffteil (1) nach Anspruch 1 und 2, **dadurch gekennzeichnet, dass** die Integration der leitenden Strukturen durch Transferverfahren (9) in das transparente Kunststoffbauteil integriert wurde.

11. Transparentes Kunststoffteil (1) nach Anspruch 1 und 2, **dadurch gekennzeichnet, dass** das transparente Kunststoffbauteil der Verscheibung für Fahrzeuge, wie zum Beispiel Fensterscheiben oder Dächern dient.

12. Transparentes Kunststoffteil (1) nach Anspruch 1 und 2, **dadurch gekennzeichnet, dass** die transparenten Kunststoffbauteile PC oder PMMA sind.

13. Transparentes Kunststoffteil (1) nach Anspruch 1 und 2, **dadurch gekennzeichnet, dass** die elektrisch leitenden Strukturen ein Antennensystem, eine Heizung oder Solarzellen sind.
